# FASCICULE DE BREVET EUROPEEN

(11) **EP 3 742 237 B1**
(45) Date de publication et mention de la délivrance du brevet: **16.10.2024**
(21) Numéro de dépôt: 19176259.0
(22) Date de dépôt: 23.05.2019
(51) Int. Cl.: G04B 17/06, G04B 13/02, G04B 15/14, B81C 1/00

(54) **COMPOSANT NOTAMMENT HORLOGER AVEC UNE TOPOLOGIE DE SURFACE ET SON PROCEDE DE FABRICATION**
KOMPONENTE, INSBESONDERE FÜR UHRWERK MIT EINER OBERFLÄCHENTOPOLOGIE, UND IHR HERSTELLUNGSVERFAHREN
COMPONENT, IN PARTICULAR FOR A TIMEPIECE, WITH A SURFACE TOPOLOGY AND MANUFACTURING METHOD THEREOF

(43) Date de publication de la demande: 25.11.2020
(73) Titulaire: Nivarox-FAR S.A., 2400 Le Locle (CH)
(72) Inventeur: VERARDO, Marco, 2336 Les Bois (CH); CHARBON, Christian, 2054 Chézard-St-Martin (CH)
(74) Mandataire: ICB SA

(56) Documents cités:
- EP-A1- 2 937 311
- EP-A1- 3 002 637
- EP-A1- 3 067 757
- EP-A1- 3 109 200
- EP-A2- 1 837 722
- EP-B1- 3 141 522
- CH-A2- 710 846
- CN-A- 101 178 124
- JP-A- 2011 158 050

## Description

### DOMAINE TECHNIQUE

La présente invention se rapporte à un composant micromécanique, utilisé notamment dans le domaine horloger, destiné à être soumis, en utilisation, à un contact par frottement avec un autre composant. Elle se rapporte également à son procédé de fabrication.

### ART ANTERIEUR

Il est connu de revêtir un composant micromécanique d'une couche fonctionnelle destinée à améliorer sa tribologie, rendre la surface conductrice ou encore résistante à l'usure. Dans le cas d'une couche conductrice, la solution la plus simple est de déposer une couche métallique typiquement par PVD. Ce dépôt est généralement relativement mou et sujet à l'usure dans les zones de frottement, par exemple au contact entre une dent de roue d'échappement et une levée d'ancre ou entre une entrée de fourchette et une cheville de plateau. La disparation complète de cette couche conductrice dans la zone de frottement a pour inconvénient de rendre la couche conductrice discontinue et donc inutile.

Le document EP 1 837 722 A2 décrit un spiral horloger en silicium recouvert d'une couche conductrice.

### RESUME DE L'INVENTION

La présente invention a pour objet de remédier à l'inconvénient précité en proposant un composant présentant dans la zone destinée à être soumise au frottement une structuration permettant en cours d'utilisation de maintenir, malgré l'usure, une couche conductrice continue entre la zone de frottement et le reste du composant.

A cet effet, le composant présente dans ladite zone, aussi dite surface fonctionnelle, une structure formée d'une succession de creusures revêtues avec la couche conductrice. Les creusures revêtues de la couche conductrice s'étendent entre deux surfaces latérales encadrant la surface fonctionnelle de manière à former une couche communiquant avec les différentes surfaces du composant également revêtues d'une couche conductrice. En cours d'usure, la couche conductrice reste au fond des creusures ce qui permet de maintenir l'intégrité et la continuité de la couche.

Préférentiellement, la structure est en forme de vaguelettes et réalisée lors de l'étape d'usinage du composant. Le procédé de fabrication utilisé est le procédé de gravure ionique réactive profonde DRIE (de l'anglais « *Deep Reactive Ion Etching* »). Ce procédé induit la formation de vaguelettes ou ondulations (en anglais « *scalloping* ») sur la tranche usinée du composant. Cette ondulation est un défaut inhérent au procédé que l'homme de métier veut, selon l'état de l'art, supprimer. A cet effet, le procédé DRIE est généralement suivi d'une étape d'oxydation et de désoxydation visant à lisser le profil ondulé. A contrario, selon l'invention, on s'affranchit de cette étape pour maintenir le profil ondulé sur la tranche du composant. Le procédé de fabrication selon l'invention permet ainsi en une seule étape d'usiner le composant et de texturer la surface. Ensuite, la couche conductrice est déposée sur toutes les surfaces du composant. Le revêtement sur les différentes surfaces peut être seulement partiel pour autant qu'il soit d'un seul tenant ou continu sur toutes les faces du composant de manière à garantir la propriété de conductivité électrique du revêtement sur tout le composant.

D'autres caractéristiques et avantages de la présente invention apparaîtront dans la description suivante de modes de réalisation préférés, présentés à titre d'exemple non limitatif en référence aux dessins annexés.

### BREVE DESCRIPTION DES FIGURES

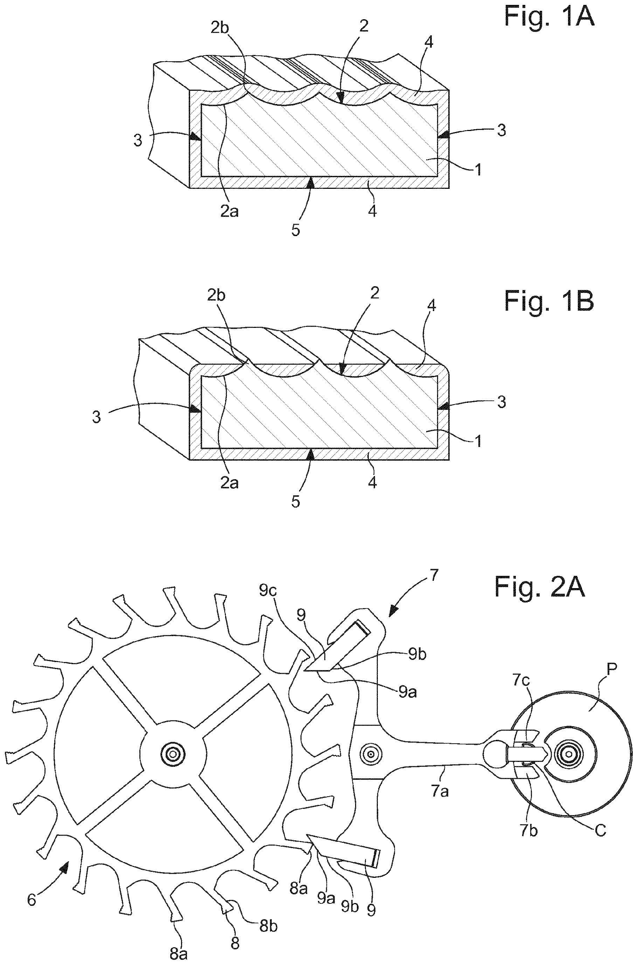

Les figures 1A et 1B représentent schématiquement en coupe et en perspective un composant, en l'occurrence une levée d'ancre, présentant sur sa surface destinée à être en contact avec un autre composant une texture en forme de vaguelettes selon l'invention. A l'état fabriqué représenté à la figure 1A, la surface destinée à être en contact avec un autre composant est complètement revêtue d'une couche électriquement conductrice. Après usure, tel que schématisé à la figure 1B, la couche conductrice subsiste uniquement dans les creusures de la texture.

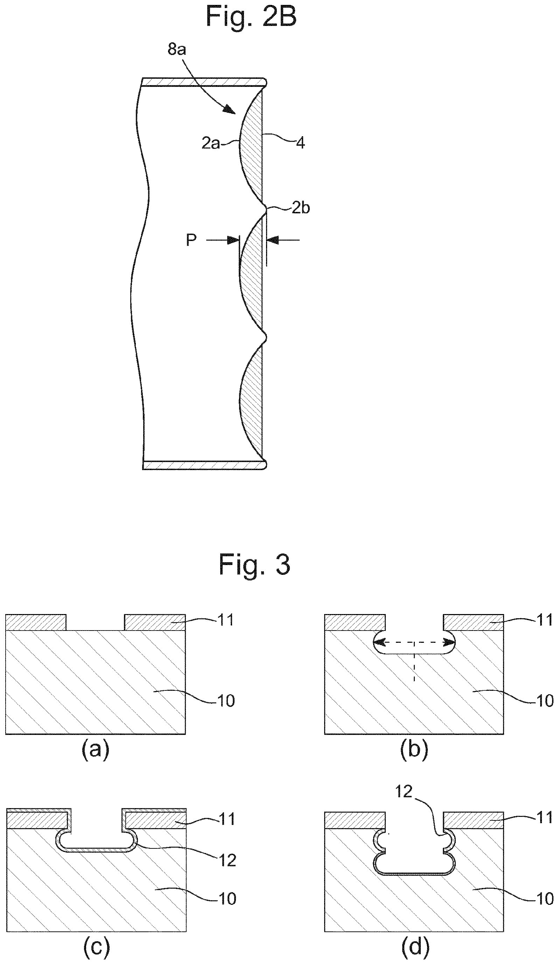

La figure 2A est une représentation d'un système horloger comprenant deux composants (roue d'échappement/ancre) qui présentent sur la tranche des dents et/ou des levées une texture selon l'invention avec la couche électriquement conductrice présente dans les creusures. La figure 2B représente schématiquement la texture sur la tranche usinée d'un des deux composants avec la couche conductrice dans les creusures.
La figure 3 illustre schématiquement, de manière connue, les différentes étapes du procédé de gravure ionique réactive profonde DRIE mis en oeuvre pour réaliser la texture selon l'invention.

### DESCRIPTION DETAILLEE

La présente invention se rapporte à un composant destiné à être soumis au frottement en utilisation. Il s'agit plus spécifiquement d'un composant réalisé dans un matériau non conducteur électrique destiné à être recouvert d'une couche conductrice permettant de libérer les charges électrostatiques accumulées lors du frotement. Par exemple, le matériau peut être à base de silicium. Dans le domaine horloger, on peut à titre d'exemple citer un composant ou les deux composants intervenant dans un système : dents d'une roue d'échappement/levées d'une ancre, entrée de fourchette d'une ancre/cheville de plateau, etc. Il peut également s'agir d'un spiral destiné à équiper un balancier à inertie fixe d'un mouvement horloger.

Tel que représenté schématiquement aux figures 1A-1B, le composant 1 présente sur sa surface fonctionnelle 2, c.à.d. sur sa surface destinée à être soumise au frottement, une texture formée d'une succession de creusures 2a, préférentiellement formant un motif périodique. Ces creusures 2a s'étendent entre deux surfaces latérales 3 encadrant la surface fonctionnelle 2. Dans l'exemple illustré, les creusures s'étendent entre deux surfaces latérales situées parallèles. De préférence, la structure de surface 2 est formée de vaguelettes périodiques avec les creusures 2a de section arrondie séparées par des crêtes 2b. Cette structure présente pour avantage de pouvoir être réalisée directement lors de l'usinage de la tranche du composant par le procédé DRIE. Selon cette variante, le contact entre le composant 1 et la surface du composant contre lequel il est destiné à frotter, s'établit au niveau des crêtes 2b de la structure de la surface 2 et les creusures 21 s'étendent dans la direction du frottement s'établissant entre les deux composants. De manière générale, les creusures peuvent avoir des sections de différentes formes (triangulaires, carrées, etc.). De même, les portions 2b encadrant les creusures 2a peuvent être planes plutôt qu'en relief. Typiquement, la profondeur P des creusures qui est la distance entre le point le plus bas et le point le plus haut de la texture est comprise entre 100 et 500 nm. Par ailleurs, les creusures peuvent s'étendre parallèlement, perpendiculairement ou de manière inclinée par rapport à la direction de frottement du composant 1 contre lequel il est destiné à frotter.

Selon l'invention telle que revendiquée, l'ensemble du composant est recouvert d'une couche électriquement conductrice 4 à l'issue de son procédé de fabrication. Ainsi, tel qu'illustré à la figure 1A, la surface fonctionnelle 2 ainsi que l'ensemble des surfaces latérales 3 et la surface arrière 5 sont entièrement revêtues d'une couche 4 électriquement conductrice à l'issue du procédé de fabrication. L'épaisseur de la couche 4 sensiblement constante est conforme, c'est-à-dire que la couche 4 suit la topologie de surface du composant et notamment de la surface fonctionnelle 2. Ensuite, au cours de l'utilisation, suite à l'usure par frottement, la couche conductrice 4 va disparaitre progressivement sur les portions 2b en crêtes qui se trouvent de part et d'autre des creusures 2a (fig.1B), les portions de la couche conductrice situées entre les crêtes 2b , voire uniquement dans le fond des creusures 2a, restant présentes et continuant d'assurer la conductivité nécessaire par exemple pour évacuer d'éventuelles accumulations de charges électrostatiques. En variante, il est également envisageable que chaque surface ne soit pas complètement revêtue avec la couche conductrice pour autant que cette dernière soit d'un seul tenant sur l'ensemble du composant. Ainsi, il est envisageable que, sur la surface fonctionnelle, seules les creusures 2a soient revêtues avec la couche conductrice 4 à l'issue du procédé de fabrication.

A titre illustratif, la figure 2A représente un système horloger comprenant une roue d'échappement 6 comprenant des dents 8 et une ancre 7 comportant deux palettes 9. Les dents 8 de la roue d'échappement 6 présentent chacune un plan d'impulsion 8a et un plan de repos 8b et les palettes 9 de l'ancre 7 présentent chacune un plan d'impulsion 9a, un plan de repos 9b et une surface 9c dite revers de la palette. L'ancre 7 comprend en outre une baguette 7a terminée par une fourchette comprenant deux cornes 7b, dont les faces 7c se faisant mutuellement face coopèrent avec une cheville de plateau C portée par un plateau P solidaire du balancier (non représenté). Dans exemple illustré, les plans d'impulsions 8a, 9a et les plans de repos 8b. 9b respectivement des dents 8 et des palettes 9 qui sont soumises au frottement présentent une texture selon l'invention avec dans les creusures 2a la couche conductrice 4 (fig.2B). Il va de soi que selon des variantes de réalisation, au moins une des surfaces parmi les plans d'impulsion 8a et 9a et les plans de repos 8b et 9b des dents respectivement des levées présente une texture selon l'invention avec dans les creusures 2a la couche conductrice 4. On pourra également envisager, selon une variante, que la surface fonctionnelle selon l'invention forme les surfaces 7c des cornes de la fourchette de l'ancre destinée à venir en contact avec la cheville de plateau C.

Dans le cas d'un spiral destiné plus spécifiquement à équiper un balancier à inertie fixe (non représenté), les deux faces de la spire extérieure du spiral et perpendiculaires au plan du spiral qui sont soumises au frottement contre respectivement les deux goupilles de la raquette lors de l'oscillation du balancier-spiral. Dès lors, au moins l'une de ces deux faces peut présenter une surface ayant la texture formée d'une succession de creusures 2a séparées par des crêtes 2b recouverte de la couche conductrice 4 selon l'invention, les lignes de crêtes s'étendant selon la direction circonférentielle des spires du spiral.

Différents procédés peuvent être envisagés pour former la structure selon l'invention. A titre d'exemple, elle peut être obtenue par usinage, attaque chimique sélective, etc. Préférentiellement, cette texture de surface est obtenue lors de l'usinage du composant par le procédé DRIE qui est un procédé de gravure par plasma qui comporte deux cycles différents se succédant, à savoir un cycle de gravure et un cycle de passivation. Le procédé est schématiquement illustré à la figure 3. De manière connue, une ébauche 10 par exemple à base de silicium est mise à disposition. Un masque ajouré 11 définissant la tranchée à usiner est formé sur la surface de l'ébauche 10 (fig.3a). Le procédé consiste ensuite en la succession des étapes de gravure (fig.3b) sous un gaz fluoré (par ex. SF₆) et de passivation (couche 12) sous un gaz fluorocarboné (par ex. C₄F₈), l'alternance des étapes de gravure et de passivation générant la structure en vaguelettes sur le flanc usiné. La périodicité et la profondeur des creusures peuvent, de manière connue, être modulées en changeant, entre autres, le temps des séquences de gravure et de passivation.

Après avoir obtenu la texture selon l'invention sur la surface fonctionnelle, la couche conductrice est déposée sur les différentes surfaces du composant. Préférentiellement, cette couche est métallique et formée d'un métal inoxydable et amagnétique tel que l'or, le platine, le rhodium, le palladium, le chrome, le titane, le vanadium etc. Typiquement, cette couche a une épaisseur inférieure ou égale à 100 nm. Elle est déposée au moyen de divers procédés connus, tels que la pulvérisation *(sputtering),* le dépôt PVD (*Physical Vapor Deposition*), l'implantation ionique ou le dépôt électrolytique.

On précisera qu'en plus de la couche conductrice, le composant peut être revêtu d'une ou plusieurs couches sous-jacentes à la couche conductrice. Par exemple, il peut s'agir dans le cas d'un spiral en silicium d'une couche dite de compensation thermique, par ex en SiO₂, qui a pour fonction de compenser les variations du coefficient thermoélastique de l'âme du spiral avec la température.

### Légende

(1) Composant
(2) Surface fonctionnelle du composant
   a. Creusure
   b. Crête ou portion
(3) Surface latérale, aussi dite surface communiquant avec la surface fonctionnelle
(4) Couche électriquement conductrice
(5) Surface ne communiquant pas avec la surface fonctionnelle, aussi dite surface opposée à la surface fonctionnelle
(6) Roue d'échappement
(7) Ancre
   a. Baguette
   b. Cornes
   c.Surface fonctionnelle des cornes
(8) Dent de la roue d'échappement
   a. Plan d'impulsion formant une surface fonctionnelle
   b. Plan de repos formant une surface fonctionnelle
(9) Palette de l'ancre
   a. Plan d'impulsion formant une surface fonctionnelle
   b. Plan de repos formant une surface fonctionnelle
   c. Revers de la palette
(10) Ebauche
(11) Masque
(12) Couche de passivation
   C : Cheville
   P : Plateau

## Revendications

1. Composant (1) horloger destiné à être en contact par frottement avec un autre composant, ledit composant (1) étant isolant électriquement et revêtu d'une couche électriquement conductrice (4) d'un seul tenant couvrant au moins partiellement chacune des surfaces du composant (1), le frottement s'établissant sur au moins une de ces surfaces, dite surface fonctionnelle (2), ladite surface fonctionnelle (2) étant encadrée d'une pluralité de surfaces latérales (3), **caractérisé en ce que** le composant (1) présente sur sa surface fonctionnelle (2) une texture formée d'une succession de creusures (2a) revêtues avec ladite couche électriquement conductrice (4), lesdites creusures (2a) s'étendant chacune entre deux surfaces latérales (3) du composant (1) de manière à maintenir la couche électriquement conductrice (4) d'un seul tenant sur tout le composant (1) ou de manière à maintenir la couche électriquement conductrice (4) au moins continue sur toutes les faces du composant pour maintenir une conductivité électrique sur l'ensemble du composant malgré l'usure causée par le frottement sur la surface fonctionnelle (2).

2. Composant (1) selon la revendication 1, **caractérisé en ce que** lesdites creusures (2a) ainsi que les portions (2b) entourant les creusures (2a) sur la surface fonctionnelle (2) sont revêtues de la couche électriquement conductrice (4), ladite couche (4) sur les portions (2b) étant susceptible de s'user en cours d'utilisation.

3. Composant (1) selon la revendication 1 ou 2, **caractérisé en ce que** lesdites creusures (2a) ont une profondeur P qui est comprise entre 100 et 500 nm.

4. Composant (1) selon l'une quelconque des revendications précédentes, **caractérisé en ce que** la succession de creusures (2a) forme une structure périodique.

5. Composant (1) selon l'une quelconque des revendications 2 à 4, **caractérisé en ce que** les creusures (2a) ont une section arrondie et sont séparées par des portions (2b) en relief, le tout formant une texture en vaguelettes.

6. Composant (1) selon l'une quelconque des revendications précédentes, **caractérisé en ce que** la couche électriquement conductrice (4) est une couche métallique.

7. Composant (1) selon la revendication 6, **caractérisé en ce que** la couche métallique est réalisée dans un métal choisi parmi l'or, le platine, le rhodium et le palladium.

8. Composant (1) selon l'une quelconque des revendications précédentes, **caractérisé en ce que** la couche (4) est telle que, en cours d'utilisation, elle couvre complètement chacune des surfaces à l'exception de la surface fonctionnelle (2) pour laquelle la couche (4) disparaît progressivement.

9. Composant (1) selon la revendication 1 **caractérisé en ce que** le composant (1) est un spiral destiné à équiper un balancier à inertie fixe.

10. Composant (1) selon la revendication 1, **caractérisé en ce que** le composant (1) est un composant d'un des systèmes suivants : roue d'échappement (6)/ancre (7), ancre (7)/plateau.

11. Composant selon la revendication 10 caractérisé en ce la surface fonctionnelle forme le plan d'impulsion et/ou le plan de repos des dents de la roues d'échappement.

12. Composant selon la revendication 10, caractérisé en ce la surface fonctionnelle forme le plan d'impulsion et/ou le plan de repos des palettes de l'ancre.

13. Composant selon la revendication 10, caractérisé en ce la surface fonctionnelle forme la surface des cornes de la fourchette de l'ancre destinée à venir en contact avec la cheville de plateau

14. Composant (1) selon l'une quelconque des revendications précédentes, **caractérisé en ce que** ledit composant (1) est à base de silicium.

15. Pièce d'horlogerie comprenant le composant (1) selon l'une quelconque des revendications précédentes.

16. Procédé de fabrication d'un composant (1) en matériau isolant, le procédé comprenant les étapes suivantes :
(a) Mise à disposition d'une ébauche (10),
(b) Usinage d'un flanc (8a,9a) sur ladite ébauche (10) par la méthode de gravure ionique réactive profonde pour réaliser le composant (1), ledit flanc usiné (8a,9a) présentant une texture en forme de vaguelettes inhérentes à la méthode de gravure ionique réactive profonde, ladite texture définissant sur le flanc usiné (8a,9a) un ensemble de creusures (2a),
(c) Dépôt d'une couche électriquement conductrice (4) sur chacune des surfaces du composant (1) y compris dans les creusures (2a).

## Patentansprüche

1. Komponente (1) für Uhrmacherei, die dazu bestimmt ist, durch Reibung mit einer anderen Komponente in Kontakt zu kommen, wobei die Komponente (1) elektrisch isolierend, und mit einer elektrisch leitenden Schicht (4) zusammenhängend beschichtet ist, die jede der Oberflächen der Komponente (1) zumindest teilweise bedeckt, wobei die Reibung auf mindestens einer dieser Oberflächen, Funktionsoberfläche (2) genannt, entsteht, wobei die Funktionsoberfläche (2) von einer Vielzahl von Seitenoberflächen (3) umrahmt ist, **dadurch gekennzeichnet, dass** die Komponente (1) auf ihrer Funktionsoberfläche (2) eine Textur aufweist, die aus einer Folge von Vertiefungen (2a) gebildet ist, die mit der elektrisch leitenden Schicht (4) beschichtet sind, wobei sich die Vertiefungen (2a) jeweils zwischen zwei Seitenoberflächen (3) der Komponente (1) erstrecken, um die elektrisch leitende Schicht (4) über die gesamte Komponente (1) zusammenhängend zu halten, oder um die elektrisch leitende Schicht (4) zumindest über alle Flächen der Komponente zusammenhängend zu halten, um eine elektrische Leitfähigkeit über die gesamte Komponente trotz des durch Reibung auf der Funktionsoberfläche verursachten Verschleißes aufrechtzuerhalten.

2. Komponente (1) nach Anspruch 1, **dadurch gekennzeichnet, dass** die Vertiefungen (2a) sowie die die Vertiefungen (2a) umgebenden Abschnitte (2b) auf der Funktionsoberfläche (2) mit der elektrisch leitenden Schicht (4) beschichtet sind, wobei sich die Schicht (4) auf den Abschnitten (2b) im Laufe der Nutzung abnutzen kann.

3. Komponente (1) nach Anspruch 1 oder 2, **dadurch gekennzeichnet, dass** die Vertiefungen (2a) eine Tiefe P aufweisen, die zwischen 100 und 500 nm liegt.

4. Komponente (1) nach einem der vorstehenden Ansprüche, **dadurch gekennzeichnet, dass** die Folge von Vertiefungen (2a) eine periodische Struktur bildet.

5. Komponente (1) nach einem der Ansprüche 2 bis 4, **dadurch gekennzeichnet, dass** die Vertiefungen (2a) einen abgerundeten Querschnitt aufweisen, und durch erhabene Abschnitte (2b) getrennt sind, wobei das Ganze eine Textur mit kleinen Wellen bildet.

6. Komponente (1) nach einem der vorstehenden Ansprüche, **dadurch gekennzeichnet, dass** die elektrisch leitende Schicht (4) eine Metallschicht ist.

7. Komponente (1) nach Anspruch 6, **dadurch gekennzeichnet, dass** die Metallschicht aus einem Metall hergestellt ist, das aus Gold, Platin, Rhodium und Palladium ausgewählt ist.

8. Komponente (1) nach einem der vorstehenden Ansprüche, **dadurch gekennzeichnet, dass** die Schicht (4) derart ist, dass sie im Laufe der Nutzung jede der Oberflächen, mit Ausnahme der Funktionsoberfläche (2), bei der die Schicht (4) allmählich verschwindet, vollständig bedeckt.

9. Komponente (1) nach Anspruch 1, **dadurch gekennzeichnet, dass** die Komponente (1) eine Spirale ist, die dazu bestimmt ist, eine Unruh mit fester Trägheit auszustatten.

10. Komponente (1) nach Anspruch 1, **dadurch gekennzeichnet, dass** die Komponente (1) eine Komponente eines der folgenden Systeme ist: Hemmungsrad (6)/Anker (7), Anker (7)/Schale.

11. Komponente nach Anspruch 10, **dadurch gekennzeichnet, dass** die Funktionsoberfläche die Impulsebene und/oder die Ruheebene der Zähne des Hemmungsrades bildet.

12. Komponente nach Anspruch 10, **dadurch gekennzeichnet, dass** die Funktionsoberfläche die Impulsebene und/oder die Ruheebene der Paletten des Ankers bildet.

13. Komponente nach Anspruch 10, **dadurch gekennzeichnet, dass** die Funktionsoberfläche die Oberfläche der Hörner der Ankergabel bildet, die dazu bestimmt ist, mit dem Schalenstift in Kontakt zu kommen.

14. Komponente (1) nach einem der vorstehenden Ansprüche, **dadurch gekennzeichnet, dass** die Komponente (1) auf Siliziumbasis ist.

15. Uhrmachereistück, das die Komponente (1) nach einem der vorstehenden Ansprüche umfasst.

16. Verfahren zur Herstellung einer Komponente (1) aus einem isolierenden Werkstoff, wobei das Verfahren die folgenden Schritte umfasst:
(a) Bereitstellen eines Rohwerks (10),
(b) Bearbeiten einer Flanke (8a, 9a) auf dem Rohwerk (10) durch das Verfahren des reaktiven lonentiefenätzens, um die Komponente (1) herzustellen, wobei die bearbeitete Flanke (8a, 9a) eine Textur mit kleinen Wellen aufweist, die dem Verfahren des reaktiven lonentiefenätzens inhärent sind, wobei die Textur auf der bearbeiteten Flanke (8a, 9a) eine Reihe von Vertiefungen (2a) definiert,
(c) Abscheiden einer elektrisch leitenden Schicht (4) auf jeder der Oberflächen der Komponente (1) auch in den Vertiefungen (2a).

## Claims

1. Watch component (1) intended to be in frictional contact with another component, said component (1) being electrically insulating and coated with a one-piece electrically conductive layer (4) at least partially covering each of the surfaces of the component (1), the friction being established on at least one of these surfaces, referred to as the functional surface (2), said functional surface (2) being framed by a plurality of lateral surfaces (3), **characterised in that** the component (1) has on its functional surface (2) a texture formed by a succession of recesses (2a) coated with said electrically conductive layer (4), said recesses (2a) each extending between two lateral surfaces (3) of the component (1) so as to keep the electrically conductive layer (4) in a single piece over the entire component (1) or so as to keep the electrically conductive layer (4) continuous at least over all the faces of the component to maintain electrical conductivity over the entire component despite the wear caused by friction on the functional surface.

2. Component (1) according to claim 1, **characterised in that** said recesses (2a) as well as the portions (2b) surrounding the recesses (2a) on the functional surface (2) are coated with the electrically conductive layer (4), said layer (4) on the portions (2b) being susceptible to wear during use.

3. A component (1) according to claim 1 or 2, **characterised in that** said recesses (2a) have a depth P which is between 100 and 500 nm.

4. Component (1) according to any one of the preceding claims, **characterised in that** the succession of recesses (2a) forms a periodic structure.

5. Component (1) according to any one of claims 2 to 4, **characterised in that** the recesses (2a) have a rounded cross-section and are separated by raised portions (2b), the whole forming a rippled texture.

6. Component (1) according to any one of the preceding claims, **characterised in that** the electrically conductive layer (4) is a metal layer.

7. Component (1) according to claim 6, **characterised in that** the metal layer is made from a metal selected from gold, platinum, rhodium and palladium.

8. Component (1) according to any one of the preceding claims, **characterised in that** the layer (4) is such that, in use, it completely covers each of the surfaces with the exception of the functional surface (2) for which the layer (4) gradually disappears.

9. Component (1) according to claim 1, **characterised in that** the component (1) is a balance spring intended to be fitted to a fixed inertia balance wheel.

10. Component (1) according to claim 1, **characterised in that** the component (1) is a component of one of the following systems: escape wheel (6)/anchor (7), anchor (7)/plate.

11. Component according to claim 10, **characterised in that** the functional surface forms the impulse plane and/or the rest plane of the escape wheel teeth.

12. Component according to claim 10, **characterised in that** the functional surface forms the impulse plane and/or the rest plane of the anchor pallets.

13. Component according to claim 10, **characterised in that** the functional surface forms the surface of the lugs of the fork of the anchor intended to come into contact with the plate pin.

14. Component (1) according to any one of the preceding claims, **characterised in that** said component (1) is silicon-based.

15. Timepiece comprising the component (1) according to any one of the preceding claims.

16. Method of manufacturing a component (1) from insulating material, the method comprising the following steps:
(a) providing a blank (10),
(b) machining a flank (8a, 9a) on said blank (10) using the deep reactive ion etching method to produce the component (1), said machined flank (8a, 9a) having a rippled texture inherent to the deep reactive ion etching method, said texture defining on the machined flank (8a, 9a) a set of recesses (2a),
(c) depositing an electrically conductive layer (4) on each of the surfaces of the component (1), including the recesses (2a).
